Europäisches Patentamt

European Patent Office

Office européen des brevets

(11) Veröffentlichungsnummer: **0 404 986 B1**

(19)

# (12) EUROPÄISCHE PATENTSCHRIFT

(45) Veröffentlichungstag der Patentschrift: **30.12.92**

(51) Int. Cl.⁵: **H01L 23/544**

(21) Anmeldenummer: **89111871.3**

(22) Anmeldetag: **29.06.89**

(54) **Schaltungsanordnung zur Identifikation integrierter Halbleiterschaltkreise.**

(43) Veröffentlichungstag der Anmeldung:
**02.01.91 Patentblatt 91/01**

(45) Bekanntmachung des Hinweises auf die
Patenterteilung:
**30.12.92 Patentblatt 92/53**

(84) Benannte Vertragsstaaten:
**AT DE FR GB IT NL**

(56) Entgegenhaltungen:
**EP-A- 0 057 645**
**EP-A- 0 133 955**
**EP-A- 0 144 680**
**DE-A- 3 601 829**
**US-A- 4 441 167**

**IBM TECHNICAL DISCLOSURE BULLETIN. vol.
25, no. 2, 01 Juli 1982, NEW YORK US Seiten
641 - 642; L. M. ARZUBI: "Very high density
PROM/ROM-memory cell in FET Si gate technology"**

(73) Patentinhaber: **SIEMENS AKTIENGESELL-
SCHAFT
Wittelsbacherplatz 2
W-8000 München 2(DE)**

(72) Erfinder: **Pribyl, Wolfgang, Dr.
Kaltenbrunngasse 7
A-8043 Graz(AT)**
Erfinder: **Sittig, Raymond, MS EE
c/o Lois Cohen 725 Pine Street
Deerfield, IL 60015(US)**

## Beschreibung

Die Erfindung betrifft eine Schaltungsanordnung zur Identifikation integrierter Halbleiterschaltkreise. Anordnungen zur Identifikation integrierter Halbleiterschaltkreise sind bereits aus EP-A 0 066 835, EP-A 0 066 836 und EP-A 0 133 955 bekannt. Weiter ist aus EP-A-0057645 eine Schaltungsanordnung bekannt, bei der programmierbare Elemente auf einem Chip angeordnet sind, und jedes Element Mit jeweils einem Anschluß des Chips verbunden ist. Sie dienen dazu, beispielsweise spezielle Schaltkreiseigenschaften wie Geschwindigkeitsklasse und mögliche Betriebsmodi des Schaltkreises auf dem Halbleiterchip selbst "notieren" zu können (z.B. Page-Mode, Nibble-Mode bei integrierten Halbleiterspeichern). Die vorgeschlagenen Lösungen haben jedoch zwei wesentliche Nachteile. Zum einen ist nur eine sehr eng begrenzte Anzahl von Identifizierungsmerkmalen in die Schaltkreise einbringbar. Zum anderen sind diese Merkmale teilweise (vgl. EP-A 0 066 835) nur auf der sogenannten Wafer-Ebene auswertbar.

Aufgabe der vorliegenden Erfindung ist es, eine Schaltungsanordnung zu schaffen, die bei minimalem Platzbedarf eine möglichst große Anzahl von Identifizierungsmerkmalen (z.B. Chargennummer) enthalten kann und deren Identifizierungsmerkmale auch dann noch auslesbar sind, wenn die Schaltkreise in ein Gehäuse eingekapselt sind.

Diese Aufgabe wird gelöst mit den im Patentanspruch 1 angegebenen Merkmalen. Vorteilhafte Aus- und Weiterbildungen sind in Unteransprüchen gekennzeichnet.

Die Erfindung wird im folgenden anhand von FIG näher erläutert.

Es zeigen

FIG 1 die erfindungsgemäße Schaltungsanordnung in einem integrierten Halbleiterschaltkreis,

die FIG 2 und 3 verschiedene Ausführungsformen der Erfindung,

FIG 4 die Ausführungsform nach FIG 2 in codiertem Zustand.

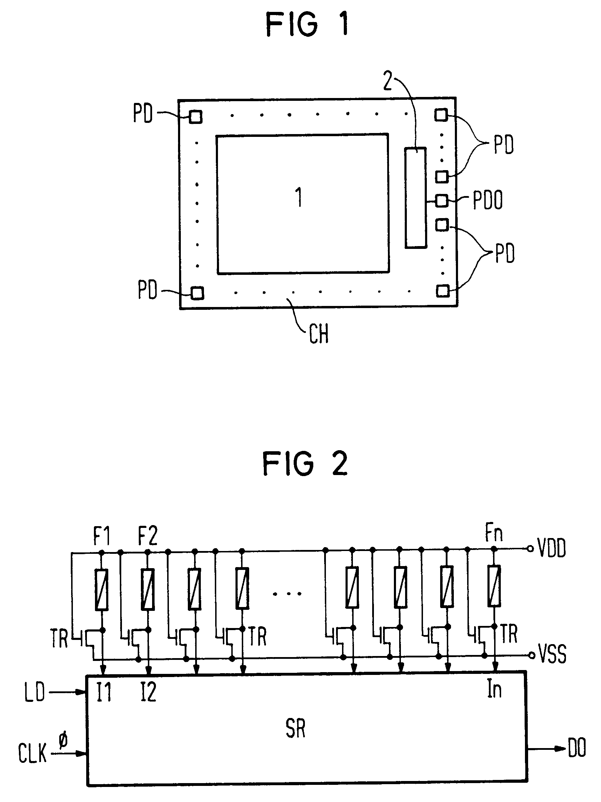

FIG 1 zeigt, stark schematisiert, in Draufsicht den Halbleiterchip CH eines integrierten Halbleiterschaltkreises mit der für den Halbleiterschaltkreis spezifischen integrierten Halbleiterschaltung 1 und deren Anschlußpads PD. Auf dem Chip CH ist weiterhin die erfindungsgemäße Schaltungsanordnung 2 dargestellt, wobei das Größenverhältnis zwischen der Schaltungsanordnung 2 und der integrierten Halbleiterschaltung 1 wesentlich zu groß bemessen ist gegenüber den technisch tatsächlich notwendigen Bedingungen. Dies dient jedoch einer Verbesserung der Anschaulichkeit. Ein Datenausgang D0 der Schaltungsanordnung 2 ist auf ein dieser speziell zugeordnetes Anschlußpad PD0 auf dem Halbleiterchip CH geführt, so daß der Datenausgang D0 über Anschlußpins auch baustein-extern zugänglich ist. Bei Verwendung einer geeigneten Multiplex-Einrichtung läßt sich jedoch auch ein auf dem Halbleiterchip CH bereits vorhandenes Anschlußpad PD als Anschlußpad PD0 für den Datenausgang D0 benutzen.

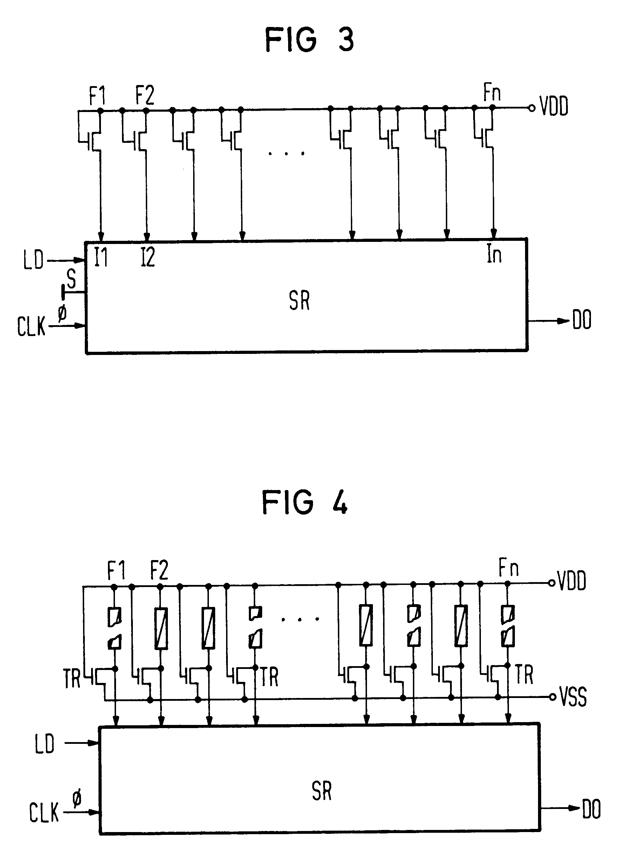

Die Ausführungsform nach FIG 2 zeigt die erfindungsgemäße Schaltungsanordnung 2 detaillierter. Sie enthält n (n = natürliche Zahl) programmierbare Elemente F1...Fn und ein n-stufiges Parallel-Serial-Schieberegister SR. Die Ausgänge der programmierbaren Elemente F1...Fn bilden je einen Paralleleingang I1 ... In des Parallel-Serial-Schieberegisters SR. FIG 2 zeigt auch den Datenausgang D0 des Parallel-Serial-Schieberegisters SR. Das Parallel-Serial-Schieberegister SR enthält weiterhin einen Steuereingang LD. Ein Aktivieren des Steuereingangs LD bewirkt eine zeitparallele Übernahme der elektrischen Zustände der programmierbaren Elemente F1...Fn in die einzelnen Registerstufen des Parallel-Serial-Schieberegisters SR als dessen Inhalt. Außerdem enthält das Parallel-Serial-Schieberegister SR einen Takteingang CLK. Mit Hilfe eines daran anlegbaren Taktsignals Ø läßt sich der Inhalt des Parallel-Serial-Schieberegisters SR bitweise an seinen Datenausgang D0 schieben. In Weiterbildung der Erfindung ist, wie in den FIG 2 und 4 dargestellt, an jedes programmierbare Element F1...Fn ausgangsseitig ein Lastelement TR angekoppelt.

Die programmierbaren Elemente F1...Fn sind mindestens während des Identifikationsvorganges eingangsseitig mit einem ersten festen elektrischen Potential verbunden. Typischerweise kann dies das eine Versorgungspotential VDD der integrierten Halbleiterschaltung 1 sein. Die programmierbaren Elemente F1...Fn sind, je nach Ausführungsform, mechanisch, thermisch oder chemisch auftrennbare Schaltelemente, insbesondere Widerstände. In der Ausführungsform nach FIG 3 sind die programmierbaren Elemente F1...Fn als Widerstand geschaltete Transistoren. Eine weitere Ausführungsform stellt die Verwendung auftrennbarer Leiterbahnen dar. Bei der in den FIG 2 und 4 gezeigten Ausführungsform sind die programmierbaren Elemente F1...Fn sogenannte "laser fuses", wie sie beispielsweise bei integrierten Halbleiterspeichern für Redundanz-Adreßdekoder verwendet werden. Zur Programmierung der programmierbaren Elemente F1...Fn können in diesem Fall die zur Programmierung von Redundanz-Adreßdekodern bereits üblichen Hilfsmittel verwendet werden. Die programmierbaren Elemente F1...Fn werden durch Auftrennen programmiert. Bei einem nicht-programmierten programmierbaren Element (z.B. programmierbares Element F2 in FIG 4) gelangt somit im wesentlichen das obengenannte feste elektrische Potential (beispielsweise das eine Versorgungspotential VDD) an den zugehörigen Paralleleingang (in FIG 4 Eingang I2) des Parallel-Serial-Schieberegisters SR.

Bei einem programmierten programmierbaren Element kommt es hingegen darauf an, ob ein Lastelement TR vorgesehen ist oder nicht. Im letzteren Fall, der in FIG 3 dargestellt ist, sind die Parallel-Eingänge I1...In des Parallel-Serial-Schieberegisters SR so auszulegen, daß sie bei Nichtbeschaltung (was der Programmierung des zugehörigen programmierbaren Elementes entspricht) schieberegister-intern auf einem weiteren elektrischen Potential liegen, das ungleich dem obengenannten festen elektrischen Potential ist. Im Falle eines programmierten programmierbaren Elementes liegt also der zugehörige Parallel-Eingang auf dem weiteren elektrischen Potential.

In dem Fall, in dem Lastelemente TR vorgesehen sind, die möglichst hochohmig mit einem zweiten festen elektrischen Potential verbunden sind, das typischerweise das andere Versorgungspotential VSS der integrierten Halbleiterschaltung 1 ist, liegt der einem programmierten programmierbaren Element (z.B. programmierbares Element F1 in FIG 4) zugeordnete Parallel-Eingang (entsprechend Parallel-Eingang I1 in FIG 4) auf dem durch das Lastelement TR vorgegebenen zweiten festen elektrischen Potential.

Es ergeben sich insgesamt also folgende mögliche Zustände der Parallel-Eingänge I1...In:
Programmierbares Element ist nicht-programmiert: Zugeordneter Parallel-Eingang liegt auf dem ersten festen elektrischen Potential;
programmierbares Element ist programmiert: Zugeordneter Parallel-Eingang liegt entweder auf dem weiteren elektrischen Potential (das günstigerweise wertemäßig gleich dem zweiten festen elektrischen Potential ist; Ausführungsform ohne Lastelemente TR) oder auf dem zweiten festen elektrischen Potential (Ausführungsform mit Lastelementen TR).

Die Erfindung ermöglicht bei Verwendung von n programmierbaren Elementen F1...Fn und einem n Bit breiten Parallel-Serial-Schieberegister SR, einen Normalzustand (alle n programmierbaren Elemente F1...Fn sind nicht-programmiert) und $2^n-1$ verschiedene Codewerte zu programmieren. Diese große Anzahl von Codewerten ist, bei auf dem Gebiet integrierter Halbleiterschaltungen üblichen geringen Flächenvorgaben, beim bekannten Stand der Technik nicht realisierbar.

Die programmierten Codes bzw. der (nicht-programmierte) Normalzustand lassen sich folgendermaßen auslesen: Zunächst werden, gesteuert über den Steuereingang LD, die an den Parallel-Eingängen I1...In anliegenden Informationen (= erstes bzw. zweites festes elektrisches Potential), die dem Zustand der programmierbaren Elemente F1...Fn entsprechen, parallel in die Stufen des Parallel-Serial-Schieberegisters SR übernommen. Durch Anlegen des Taktsignales Ø an den Takteingang CLK sind diese Informationen über den Datenausgang D0 des Parallel-Serial-Schieberegisters SR auslesbar. Sie sind damit beispielsweise am Pad PD0 des Halbleiterschaltkreises abnehmbar und über einen an dieses angeschlossenen Bausteinanschluß auch Halbleiterschaltkreisextern verfügbar. Der Datenausgang D0 kann aber auch mit der Halbleiterschaltung 1 verbunden sein. Es lassen sich also der integrierte Halbleiterschaltkreis und beispielsweise seine technischen Eigenschaften entsprechend identifizieren.

Verwendet man für das Parallel-Serial-Schieberegister SR beispielsweise ein in sogenannten Zellbibliotheken bereitgestelltes übliches Schieberegister oder Teile davon, so ist ein dort möglicherweise vorhandener zusätzlicher Serial-Eingang S des Schieberegisters vorteilhafterweise elektrisch inaktiv zu schalten, beispielsweise durch feste Beschaltung mit dem anderen Versorgungspotential VSS der integrierten Halbleiterschaltung 1.

## Patentansprüche

1. Schaltungsanordnung zur Identifikation integrierter Halbleiterschaltkreise auf einem Halbleiterchip
   - mit n programmierbaren Elementen (F1...Fn) und einem Parallel-Serial-Schieberegister (SR) mit n Parallel-Eingängen (I1.. In) und einem Datenausgang (D0),
   - bei der der Ausgang jedes programmierbaren Elementes (F1...Fn) mi jeweils einem der Parallel-Eingäng (I1...In) des Parallel-Serial-Schieberegisters (SR) elektrisch verbunden ist,
   - bei der das Parallel-Serial-Schieberegister (SR) einen Steuereingang (LD) aufweist zur Übernahme der elektrischen Zustände der programmierbaren Elemente (F1...Fn) in das Parallel-Serial-Schieberegister (SR),
   - bei der das Parallel-Serial-Schieberegister (SR) einen Takteingang (CLK) aufweist zur Steuerung der Schiebefunktion des Parallel-Serial-Schieberegisters (SR) in Abhängigkeit von einem Taktsignal (Ø), das an den Takteingang (CLK) anlegbar ist, und
   - bei der der Datenausgang des Schieberegisters mit einem Anschlußpad des Halbleiterchips elektrisch verbunden ist.

2. Schaltungsanordnung nach Anspruch 1, **dadurch gekennzeichnet,** daß die programmierbaren Elemente (F1...Fn) mechanisch, thermisch oder chemisch auftrennbare Schaltelemente sind.

3. Schaltungsanordnung nach Anspruch 2, **dadurch gekennzeichnet,** daß die auftrennbaren Schaltelemente Widerstände sind.

4. Schaltungsanordnung nach Anspruch 3, **dadurch gekennzeichnet,** daß die Widerstände als Widerstand geschaltete Transistoren sind.

5. Schaltungsanordnung nach Anspruch 1 oder 2, **dadurch gekennzeichnet,** daß die programmierbaren Elemente (F1.. .Fn) Laser fuses sind.

6. Schaltungsanordnung nach Anspruch 1 oder 2, **dadurch gekennzeichnet,** daß die programmierbaren Elemente (F1...Fn) auftrennbare Leiterbahnen sind.

7. Schaltungsanordnung nach einem der vorhergehenden Ansprüche, **dadurch gekennzeichnet,** daß an jedes programmierbare Element (F1...Fn) ausgangsseitig ein Lastelement (TR) angekoppelt ist.

8. Schaltungsanordnung nach einem der vorhergehenden Ansprüche, **dadurch gekennzeichnet,** daß ein beim Parallel-Serial-Schieberegister (SR) vorhandener Serialeingang (S) elektrisch inaktiv geschaltet ist.

**Claims**

1. Circuit configuration for the identification of integrated semiconductor circuits on a semiconductor chip,
   - having n programmable elements (F1...Fn) and a parallel-serial shift register (SR) with n parallel inputs (I1...In) and a data output (DO),
   - in which the output of each programmable element (F1...Fn) is electrically connected to in each case one of the parallel inputs (I1...In) of the parallel-serial shift register (SR),
   - in which the parallel-serial shift register (SR) has a control input (LD) for transferring the electrical states of the programmable elements (F1...Fn) into the parallel-serial shift register (SR),
   - in which the parallel-serial shift register (SR) has a clock input (CLK) for controlling the shift function of the parallel-serial shift register (SR) as a function of a clock signal (ø) which can be applied to the clock input (CLK), and
   - in which the data output of the shift register is electrically connected to a connection pad of the semiconductor chip.

2. Circuit configuration according to Claim 1, characterised in that the programmable elements (F1...Fn) are switching elements that can be disconnected mechanically, thermally or chemically.

3. Circuit configuration according to Claim 2, characterised in that the disconnectable switching elements are resistors.

4. Circuit configuration according to Claim 3, characterised in that the resistors are transistors switched as resistors.

5. Circuit configuration according to Claim 1 or 2, characterised in that the programmable elements (F1...Fn) are laser fuses.

6. Circuit configuration according to Claim 1 or 2, characterised in that the programmable elements (F1...Fn) are disconnectable conductor tracks.

7. Circuit configuration according to one of the preceding claims, characterised in that a load element (TR) is coupled to each programmable element (F1...Fn) on the output side.

8. Circuit configuration according to one of the preceding claims, characterised in that a serial input (S) provided in the parallel-serial shift register (SR) is switched to be electrically inactive.

**Revendications**

1. Montage pour identifier des circuits intégrés à semiconducteurs sur une plaquette à semiconducteurs, comportant
   - n éléments programmables (F1...Fn) et un registre à décalage parallèle-série (SR) comportant n entrées parallèles (I1...In) et une sortie de données (D0),
   - et dans lequel la sortie de chaque élément programmable (F1 ...Fn) est raccordée électriquement respectivement à l'une des entrées parallèles (I1...In) du registre à décalage parallèle-série (SR),
   - dans lequel le registre à décalage parallèle-série (SR) possède une entrée de commande (LD) pour le transfert des états électriques des éléments programmables (F1...Fn) dans le registre à décalage parallèle-série (SR),

- dans lequel le registre à décalage parallèle-série (SR) possède une entrée de cadence (CLK) pour la commande de la fonction de transfert du registre à décalage parallèle-série (SR) en fonction d'un signal de cadence ($\phi$), qui peut être appliqué à l'entrée de cadence (CLK), et
- dans lequel la sortie de données du registre à décalage est raccordée électriquement à un plot de raccordement de la microplaquette à semiconducteurs.

2. Montage suivant la revendication 1, caractérisé par le fait que les éléments programmables (F1...Fn) sont des éléments de coupure pouvant être rompus mécaniquement, thermiquement ou chimiquement.

3. Montage suivant la revendication 2, caractérisé par le fait que les éléments de coupure pouvant être rompus sont des résistances.

4. Montage suivant la revendication 3, caractérisé par le fait que les résistances sont des transistors montés en résistance.

5. Montage suivant la revendication 1 ou 2, caractérisé par le fait que les éléments programmables (F1... Fn) sont des fusibles laser.

6. Montage suivant la revendication 1 ou 2, caractérisé par le fait que les éléments programmables (F1... Fn) sont des voies conductrices pouvant être rompues.

7. Montage suivant les revendications précédentes, caractérisé par le fait qu'un élément de charge (TR) est accouplé au côté sortie de chaque élément programmable (F1...Fn).

8. Montage suivant l'une des revendications précédentes, caractérisé par le fait qu'une entrée série (S) présente dans le registre à décalage parallèle-série (SR) est rendue inactive électriquement.

# FIG 1

# FIG 2

# FIG 3

# FIG 4